# EUROPEAN PATENT APPLICATION

(11) **EP 4 685 799 A1**
(43) Date of publication of application: **28.01.2026**
(21) Application number: 24933178.6
(22) Date of filing: 25.10.2024
(51) Int. Cl.: G11C 11/4091

(54) **MEMORY CIRCUIT**

(30) Priority: 04.06.2024 CN 202410720494
(71) Applicant: CXMT Corporation, Hefei, Anhui 230601 (CN)
(72) Inventor: SHANG, Weibing, Hefei, Anhui 230601 (CN); GAO, Yicheng, Hefei, Anhui 230601 (CN)
(74) Representative: Gulde & Partner
(86) International application number: PCT/CN2024/127274
(87) International publication number: WO 2025/251504

(57) **Abstract**

The present disclosure provides a memory circuit, which may at least include: an amplifier, the amplifier having a first node and a second node, the first node being electrically connected to a first data line, the second node being electrically connected to a first reference data line, and the amplifier being configured to amplify a voltage difference between the first data line and the first reference data line; and a first pass transistor, the first pass transistor being electrically connected to the first node and a second data line, and the first pass transistor being configured to be turned on based on a control signal in at least a part of a time period at a read/write stage, and be turned on based on the control signal in at least a part of a time period at an idle stage.

## Description

### CROSS-REFERENCE TO RELATED APPLICATIONS

This application claims priority to Chinese Patent Application No. 202410720494.4, filed with the China National Intellectual Property Administration on June 4, 2024 and entitled "MEMORY CIRCUIT", which is incorporated herein by reference in its entirety.

### TECHNICAL FIELD

Embodiments of this application relate to the semiconductor field, and in particular, to a memory circuit.

### BACKGROUND

With further miniaturization of a manufacturing process and further market requirements on a chip size, a pressure of a memory manufacturer on reducing the chip size is increasingly high. However, during miniaturization of the manufacturing process, an original deficiency generally does not disappear, but may become more serious, e.g., a transistor matching problem. Therefore, an overall size cannot be reduced by reducing a quantity of transistors to be disposed for implementing specific functions, but instead, the overall size is optimized based on a reasonable layout floorplan.

### SUMMARY

An embodiment of this application provides a memory circuit, which is at least conducive to further reducing a size of the memory circuit.

According to some embodiments of this application, an embodiment of this application provides a memory circuit, including: an amplifier, the amplifier having a first node and a second node, the first node being electrically connected to a first data line, the second node being electrically connected to a first reference data line, and the amplifier being configured to amplify a voltage difference between the first data line and the first reference data line; and a first pass transistor, a first terminal of the first pass transistor being electrically connected to the first node, a second terminal of the first pass transistor being electrically connected to a second data line, and the first pass transistor being configured to be turned on based on a control signal in at least a part of a time period at a read/write stage, and be turned on based on the control signal in at least a part of a time period at an idle stage.

The memory circuit further includes a second pass transistor. A first terminal of the second pass transistor is electrically connected to the second node, and a second terminal of the second pass transistor is electrically connected to a second reference data line. At least one of the first pass transistor and the second pass transistor is configured to be turned on based on a control signal in at least a part of a time period at a read/write stage, and be turned on based on the control signal in at least a part of a time period at an idle stage.

At a same idle stage, the first pass transistor or the second pass transistor is turned on, and at different idle stages, the first pass transistor and the second pass transistor are turned on alternately.

The first data line is a bit line, the first reference data line is a reference bit line, the second data line is a local data line, the first pass transistor is a first column selection transistor, the local data line is electrically connected to the bit line through the first column selection transistor, the control signal is a column selection signal, and the first column selection transistor is turned on based on the column selection signal to adjust a potential of the first node to be equal to a potential of the local data line.

The amplifier includes a first P-type amplification transistor, a second P-type amplification transistor, a first N-type amplification transistor, and a second N-type amplification transistor. A first terminal of the first P-type amplification transistor and a first terminal of the second P-type amplification transistor are connected to a first voltage node. A second terminal of the first P-type amplification transistor is connected to a first terminal of the first N-type amplification transistor, and a second terminal of the second P-type amplification transistor is connected to a first terminal of the second N-type amplification transistor. A second terminal of the first N-type amplification transistor and a second terminal of the second N-type amplification transistor are connected to a second voltage node. The second terminal of the first P-type amplification transistor serves as the first node, and the second terminal of the second P-type amplification transistor serves as the second node. The first node is connected to a gate of the second P-type amplification transistor and a gate of the second N-type amplification transistor, and the second node is connected to a gate of the first P-type amplification transistor and a gate of the first N-type amplification transistor.

The amplifier includes a first P-type amplification transistor, a second P-type amplification transistor, a first N-type amplification transistor, a second N-type amplification transistor, a first isolation transistor, a second isolation transistor, a first offset cancellation transistor, and a second offset cancellation transistor. A first terminal of the first P-type amplification transistor and a first terminal of the second P-type amplification transistor are connected to a first voltage node. A second terminal of the first P-type amplification transistor is connected to a first terminal of the first N-type amplification transistor, and a second terminal of the second P-type amplification transistor is connected to a first terminal of the second N-type amplification transistor. A second terminal of the first N-type amplification transistor and a second terminal of the second N-type amplification transistor are connected to a second voltage node. The second terminal of the first P-type amplification transistor serves as the second node, and the second terminal of the second P-type amplification transistor serves as the first node. The first node is connected to a first terminal of the first isolation transistor and a gate of the first P-type amplification transistor. A second terminal of the first isolation transistor, a second terminal of the first offset cancellation transistor, and a gate of the first N-type amplification transistor are connected to the bit line. A first terminal of the first offset cancellation transistor is connected to the second node, and the second node is connected to a first terminal of the second isolation transistor and a gate of the second P-type amplification transistor. A second terminal of the second isolation transistor, a second terminal of the second offset cancellation transistor, and a gate of the second N-type amplification transistor are connected to the reference bit line. A first terminal of the second offset cancellation transistor is connected to the first node, the first isolation transistor and the second isolation transistor are turned on based on an isolation signal, and the first offset cancellation transistor and the second offset cancellation transistor are turned on based on an offset cancellation signal.

The first terminal of the first pass transistor is electrically connected to the bit line and is electrically connected to the first node through the bit line and the first isolation transistor.

The first terminal of the first pass transistor is electrically connected to the first node and is electrically connected to the bit line through the first node and the first isolation transistor.

The read/write stage includes an offset cancellation stage, a charge sharing stage, and an amplification stage that are successively performed. The first pass transistor is further configured to be turned on based on the control signal in at least a part of a time period at the charge sharing stage, and at the charge sharing stage, a turn-on moment of the first isolation transistor and the second isolation transistor is later than a turn-off moment of the first pass transistor.

The first pass transistor is configured to be turned on based on the control signal generated by a column operation command in at least a part of a time period at the read/write stage, and be turned on based on the control signal generated by a row operation command in at least a part of a time period at the idle stage.

The column operation command includes a read command and a write command, and the row operation command includes a precharge command.

The first data line is a local data line, the first reference data line is a local reference data line, and the second data line is a global data line. The global data line is connected to the local data line through the first pass transistor to adjust a potential at the first terminal of the first pass transistor to be equal to a potential at the second terminal of the first pass transistor.

The memory circuit further includes a bank. The bank includes a row decoder, a column decoder, and a half bank located on two opposite sides of the row decoder. Both the amplifier and the first pass transistor are disposed in the half bank, and the column decoder is located between the row decoder and the half bank.

The column decoder includes multiple column decoding circuits, the half bank includes multiple sections arranged in a direction of a bit line, each of the column decoding circuits is configured to perform column decoding for some corresponding sections in the multiple sections, and each of the column decoding circuits corresponds to a fixed quantity of the sections.

The memory circuit further includes a first semiconductor structure and a second semiconductor structure that are stacked. The bit line and a memory cell connected to the bit line are disposed in the first semiconductor structure, and multiple repeating units are disposed in the second semiconductor structure. Each repeating unit includes an amplification array and a row decoder located on two opposite sides of the amplification array in a first direction, and a column decoder located on two opposite sides of the amplification array in a second direction. The first direction is perpendicular to the second direction.

The memory circuit further includes a first memory array, a second memory array, a first amplification array, and a second amplification array. The first memory array, the first amplification array, the second amplification array, and the second memory array are successively arranged in an extension direction of the bit line. The amplifier is disposed in the first amplification array and the second amplification array. The first pass transistor is disposed between the first amplification array and the first memory array, and is disposed between the second amplification array and the second memory array.

A local amplifier is further disposed between the first amplification array and the second amplification array, and the local amplifier is configured to amplify a voltage difference between the local data line and a local reference data line.

In the extension direction of the bit line, in the amplifier, the first N-type amplification transistor, the first offset cancellation transistor, the first isolation transistor, the first P-type amplification transistor, the second P-type amplification transistor, the second isolation transistor, the second offset cancellation transistor, and the second N-type amplification transistor are successively arranged; or the first isolation transistor, the first offset cancellation transistor, the first N-type amplification transistor, the second N-type amplification transistor, the second offset cancellation transistor, the second isolation transistor, the first P-type amplification transistor, and the second P-type amplification transistor are successively arranged; or the first P-type amplification transistor, the second P-type amplification transistor, the first isolation transistor, the first offset cancellation transistor, the first N-type amplification transistor, the second N-type amplification transistor, the second offset cancellation transistor, and the second isolation transistor are successively arranged.

The first offset cancellation transistor shares an active region with the first N-type amplification transistor, and the shared active region is connected to a metal layer through a corresponding contact hole.

### BRIEF DESCRIPTION OF DRAWINGS

One or more embodiments are exemplified with the figures in the accompanying drawings corresponding to the one or more embodiments. These example descriptions are not intended to limit the embodiments, and unless specifically stated, no scale limitations are constituted by the figures in the accompanying drawings.
FIG. 1 is a schematic circuit diagram of a memory circuit;
FIG. 2 is a schematic diagram of a layout of a memory circuit shown in FIG. 1;
FIG. 3 shows a memory circuit according to an embodiment of this application;
FIG. 4 shows a memory circuit according to another embodiment of this application;
FIG. 5 is a timing diagram of a control signal according to an embodiment of this application;
FIG. 6 to FIG. 8 are schematic circuit diagrams of multiple memory circuits according to this application;
FIG. 9 is a diagram of control signal timing and node potential changing of the memory circuit shown in FIG. 1;
FIG. 10 is a diagram of control signal timing and node potential changing of the memory circuit shown in FIG. 6;
FIG. 11 is a diagram of control signal timing and node potential changing of the memory circuit shown in FIG. 8;
FIG. 12 is a schematic architectural diagram of a memory circuit according to an embodiment of this application;
FIG. 13 is a schematic architectural diagram of a memory circuit;
FIG. 14 is a schematic architectural diagram of a memory circuit according to another embodiment of this application;
FIG. 15 is a schematic floorplan diagram of a memory circuit according to an embodiment of this application; and
FIG. 16 to FIG. 18 are schematic diagrams of multiple layouts of a memory circuit according to this application.

### DESCRIPTION OF EMBODIMENTS

The embodiments of this application are described in detail below with reference to the accompanying drawings. However, it may be understood by a person of ordinary skill in the art that in the embodiments of this application, many technical details are provided to enable readers to better understand this application. However, the technical solutions claimed in this application may be implemented even without these technical details and various variations and modifications made based on the following embodiments.

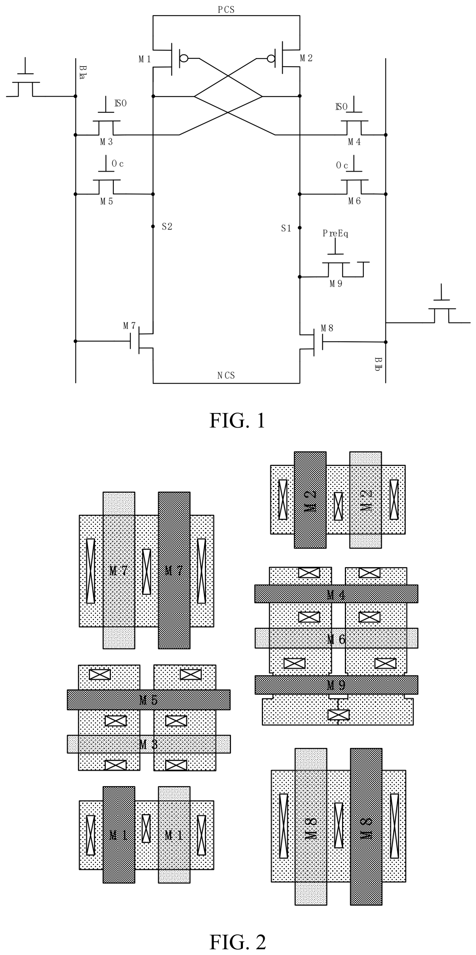

FIG. 1 is a schematic circuit diagram of a memory circuit. FIG. 2 is a schematic diagram of a layout of a memory circuit shown in FIG. 1.

Referring to FIG. 1, the memory circuit includes an amplifier. The amplifier includes a first P-type amplification transistor M1, a second P-type amplification transistor M2, a first N-type amplification transistor M7, a second N-type amplification transistor M8, a first isolation transistor M3, a second isolation transistor M4, a first offset cancellation transistor M5, a second offset cancellation transistor M6, and a precharge transistor M9. A first terminal of the first P-type amplification transistor M1 and a first terminal of the second P-type amplification transistor M2 are connected to a first voltage node PCS. A second terminal of the first P-type amplification transistor M1 is connected to a first terminal of the first N-type amplification transistor M7, and a second terminal of the second P-type amplification transistor M2 is connected to a first terminal of the second N-type amplification transistor M8. A second terminal of the first N-type amplification transistor M7 and a second terminal of the second N-type amplification transistor M8 are connected to a second voltage node NCS. The second terminal of the first P-type amplification transistor M1 serves as the second node S2, and the second terminal of the second P-type amplification transistor M2 serves as the first node S1. The first node S1 is connected to a first terminal of the first isolation transistor M3. A second terminal of the first isolation transistor M3, a second terminal of the first offset cancellation transistor M5, and a gate of the first N-type amplification transistor M7 are connected to the bit line Bla. A first terminal of the first offset cancellation transistor M5 is connected to the second node S2, and the second node S2 is connected to a first terminal of the second isolation transistor M4. A second terminal of the second isolation transistor M4, a second terminal of the second offset cancellation transistor M6, and a gate of the second N-type amplification transistor M8 are connected to the reference bit line Blb. A first terminal of the second offset cancellation transistor M6 and a first terminal of the precharge transistor M9 are connected to the first node S1, the first isolation transistor M3 and the second isolation transistor M4 are turned on based on an isolation signal ISO, and the first offset cancellation transistor M5 and the second offset cancellation transistor M6 are turned on based on an offset cancellation signal Oc. The precharge transistor M9 is turned on based on a precharge signal PreEq and transmits a precharge potential to the first node S1. The first P-type amplification transistor M1 and the second P-type amplification transistor M2 form a P-type amplifier PSA, and the first N-type amplification transistor M7 and the second N-type amplification transistor M8 form an N-type amplifier NSA.

It can be learned from a schematic diagram of a layout of FIG. 2 that, due to existence of the precharge transistor M9 in FIG. 1, layout structures on the left and right sides of the amplifier are different, and cannot be symmetrical. A height of the layout structure on the right side is always greater than a height of the layout structure on the left side. However, because the precharge transistor M9 plays a specific role in the amplifier, a size of the layout structure cannot be reduced by simply removing the precharge transistor M9. In addition, the precharge transistor is not only disposed in the circuit shown in FIG. 1, but also may be disposed in another circuit, so as to precharge an internal node of another circuit structure.

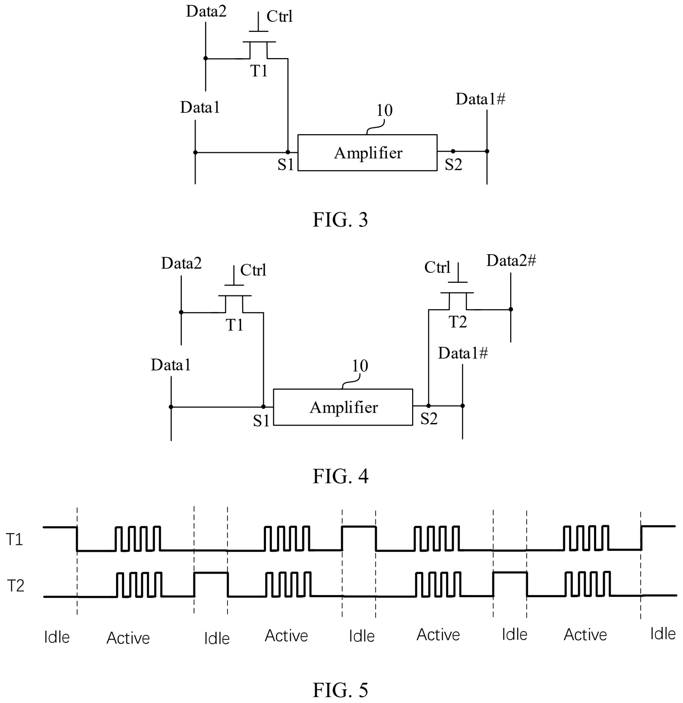

FIG. 3 shows a memory circuit according to an embodiment of this application. The memory circuit includes: an amplifier 10, the amplifier 10 having a first node S1 and a second node S2, the first node S1 being electrically connected to a first data line Data1, the second node S2 being electrically connected to a first reference data line Data1#, and the amplifier 10 being configured to amplify a voltage difference between the first data line Data1 and the first reference data line Data1#; and a first pass transistor T1, a first terminal of the first pass transistor T1 being electrically connected to the first node S1, a second terminal of the first pass transistor T1 being electrically connected to a second data line Data2, and the first pass transistor T1 being configured to be turned on based on a control signal Ctrl in at least a part of a time period at a read/write stage, and be turned on based on the control signal Ctrl in at least a part of a time period at an idle stage.

In this application, the pass transistor is turned on at the idle stage, so that the first node S1 can receive a potential at another terminal of the first pass transistor T1. In this way, the second data line Data2 may be controlled to have a precharge potential during turn-on of the first pass transistor T1, so that the first node S1 has a precharge potential. In other words, at the idle stage, the first pass transistor T1 functions as the precharge transistor, and is configured to transmit the precharge potential to the first node S1. In this application, at the read/write stage, data of a specific bit line that needs to be read may be determined based on column address information, and then a corresponding first pass transistor T1 is turned on to read/write data. However, at the idle stage, no read/write operation needs to be performed, so that the first pass transistor T1 may be turned on to ensure that a potential of the first node S1 is the same as a potential of the second data line Data2, so that the first node S1 obtains the precharge potential.

Internal noise of the amplifier 10 may be reduced by controlling the first node S1 of the amplifier 10 to be at the precharge potential. Inside the amplifier 10, the first node S1 and the second node S2 may be electrically connected. "Electrically connected" means that after a switching transistor between the first node S1 and the second node S2 is turned on, the first node S1 and the second node S2 are connected together through a source-drain of the switching transistor, so that the potential of the second node S2 is also at the precharge potential. Alternatively, inside the amplifier 10, the potential of the first node S1 is configured to control the potential of the second node S2. After the potential of the first node S1 is at the precharge potential, the corresponding transistor is controlled to be in a specific on state, so that the second node S2 at a source or drain of the corresponding transistor is also at the precharge potential. An internal structure of the amplifier 10 is not limited in this application, provided that the first node S1 can be stably at the precharge potential, which helps reduce the internal noise of the amplifier 10.

In a case of no additional limitation, "electrical connection" in this application means that two nodes or two wires are connected together through source-drains of one or more switching transistors. In a connection process, any party of the electrical connection does not serve as a control signal of a transistor to play a role for the connection, but is not prevented from serving as a control signal to play a role for another function.

In an embodiment, the second data line Data2 may be completely at a precharge potential at the idle stage, and the first pass transistor T1 is always turned on at the idle stage, so that the first node S1 is stably at the precharge potential. In another embodiment of this application, the second data line Data2 may be at the precharge potential in a part of a time period at the idle stage. In this case, the first pass transistor T1 is turned on, and after the potential of the first node S1 is pulled to the precharge potential, the first pass transistor T1 is turned off.

Change of the potential of the second data line Data2 at the idle stage. In an embodiment, the precharge potential of the second data line Data2 may be provided by a corresponding power supply. In other words, a power supply originally providing a precharge potential for the second data line Data2 at the idle stage now further provides a precharge potential for the first node S1. In still another embodiment, after the potential of the first node S1 is pulled to the precharge potential, the first pass transistor T1 may be turned off, and the potential of the second data line Data2 is adjusted to another value, for example, a supply voltage VCC or a low level VSS. In this case, compared with FIG. 1, it is equivalent to adjusting the precharge transistor M9 that provides the precharge potential for the internal node of the amplifier 10 to precharge the second data line Data2. When multiple first data lines Data1 are connected to the same second data line Data2 through the corresponding first pass transistor T1, adjusting the precharge transistor to precharge the second data line Data2 also helps reduce a total quantity of precharge transistors, thereby reducing an overall size.

In an embodiment, referring to FIG. 4, the memory circuit further includes a second pass transistor T2. A first terminal of the second pass transistor T2 is electrically connected to the second node S2, and a second terminal of the second pass transistor T2 is electrically connected to a second reference data line Data2#. At least one of the first pass transistor T1 and the second pass transistor T2 is configured to be turned on based on a control signal Ctrl in at least a part of a time period at a read/write stage, and be turned on based on the control signal Ctrl in at least a part of a time period at the idle stage. In some other embodiments, the second pass transistor T2 and the second reference data line Data2# are not mandatory, and only the second data line Data2 may be employed to perform reading/writing, and serve as a source of the precharge potential. If the second reference data line Data2# is disposed, and the second reference data line Data2# receives data originating from the first reference data line Data1#, data in the second data line Data2 is generally opposite to data in the second reference data line Data2#, so as to form a differential signal and reduce impact of noise on data accuracy. In addition, another amplifier may be disposed to amplify a voltage difference between the second data line Data2 and the second reference data line Data2#.

In an embodiment, at a same idle stage, the first pass transistor T1 or the second pass transistor T2 is turned on, and at different idle stages, the first pass transistor and the second pass transistor are turned on alternately. Referring to FIG. 5, an example in which the first pass transistor T1 and the second pass transistor T2 are NMOS transistors is taken. FIG. 5 is a signal timing diagram of a control signal Ctrl received by the first pass transistor T1 and the second pass transistor T2. It can be learned that at the same idle stage Idle, only the first pass transistor T1 or the second pass transistor T2 is turned on, and at different idle stages Idle, the first pass transistor T1 and the second pass transistor T2 are turned on alternately. It should be noted that, at the read/write stage Active, multiple high-level pulses received by the first pass transistor T1 and the second pass transistor T2 do not mean that the same first pass transistor/second pass transistor is consecutively turned on for multiple times, but mean that, at the read/write stage, multiple first pass transistors T1/multiple second pass transistors T2 corresponding to multiple first data lines Data1 are successively turned on. Herein, an example in which only four first pass transistors T1 and four second pass transistors T2 are successively turned on is taken. Actually, a larger quantity or a smaller quantity of first pass transistors T1 and second pass transistors T2 may be turned on based on a data reading requirement.

In an embodiment, referring to FIG. 3, FIG. 4, and FIG. 6, the first data line Data1 is a bit line Bla, the first reference data line Data1# is a reference bit line Blb, the second data line Data2 is a local data line IO, the first pass transistor T1 is a first column selection transistor M10, the local data line IO is electrically connected to the bit line Bla through the first column selection transistor M10, the control signal Ctrl is a column selection signal CSL, and the first column selection transistor M10 is turned on based on the column selection signal CSL to adjust a potential of the first node S1 to be equal to a potential of the local data line IO. In another embodiment, the first data line may alternatively be a local data line, and the second data line is a global data line.

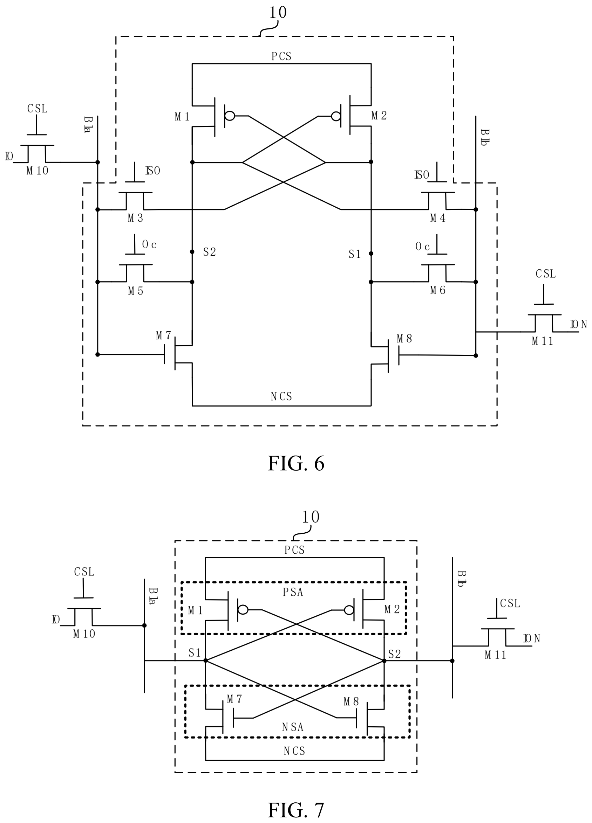

Further referring to FIG. 6, in an embodiment, the amplifier 10 includes a first P-type amplification transistor M1, a second P-type amplification transistor M2, a first N-type amplification transistor M7, a second N-type amplification transistor M8, a first isolation transistor M3, a second isolation transistor M4, a first offset cancellation transistor M5, and a second offset cancellation transistor M6. A first terminal of the first P-type amplification transistor M1 and a first terminal of the second P-type amplification transistor M2 are connected to a first voltage node PCS. A second terminal of the first P-type amplification transistor M1 is connected to a first terminal of the first N-type amplification transistor M7, and a second terminal of the second P-type amplification transistor M2 is connected to a first terminal of the second N-type amplification transistor M8. A second terminal of the first N-type amplification transistor M7 and a second terminal of the second N-type amplification transistor M8 are connected to a second voltage node NCS. The second terminal of the first P-type amplification transistor M1 serves as the second node S2, and the second terminal of the second P-type amplification transistor M2 serves as the first node S1. The first node S1 is connected to a first terminal of the first isolation transistor M3 and a gate of the first P-type amplification transistor M1. A second terminal of the first isolation transistor M3, a second terminal of the first offset cancellation transistor M5, and a gate of the first N-type amplification transistor M7 are connected to the bit line Bla. A first terminal of the first offset cancellation transistor M5 is connected to the second node S2, and the second node S2 is connected to a first terminal of the second isolation transistor M4 and a gate of the second P-type amplification transistor M2. A second terminal of the second isolation transistor M4, a second terminal of the second offset cancellation transistor M6, and a gate of the second N-type amplification transistor M8 are connected to the reference bit line Blb. A first terminal of the second offset cancellation transistor M6 is connected to the first node S1, the first isolation transistor M3 and the second isolation transistor M4 are turned on based on an isolation signal ISO, and the first offset cancellation transistor M5 and the second offset cancellation transistor M6 are turned on based on an offset cancellation signal Oc.

In this embodiment, the first isolation transistor M3 and the second isolation transistor M4 are disposed, so that a moment at which a voltage of the bit line Bla is transmitted to the first node S1 can be controlled as required, and a moment at which a potential of the first node S1/the second node S2 is transmitted to the bit line Bla and/or the reference bit line Blb can also be controlled. In addition, the first offset cancellation transistor M5 and the second offset cancellation transistor M6 are further disposed to eliminate a performance parameter mismatch between the first N-type amplification transistor M7 and the second N-type amplification transistor M8. In this embodiment, no precharge transistor is disposed in the amplifier 10, but a first column selection transistor M10 is employed to receive a potential of the local data line IO at the idle stage, so as to adjust the potential of the first node S1 to the precharge potential.

In an embodiment, the memory circuit further includes a second pass transistor. The second pass transistor is a second column selection transistor M11 receiving a column selection signal CSL, one terminal of the second column selection transistor M11 is electrically connected to the second node S2, and the other terminal of the second column selection transistor M11 is connected to the second reference data line ION. At the idle stage, the second column selection transistor M11 may receive a potential of the second reference data line ION, so as to adjust the potential of the second node S2 to the precharge potential. It should be noted that there are multiple parallel manners of adjusting the potentials of the first node S1 and/or the second node S2 to the precharge potential. This is related to whether the amplifier 10 includes the second pass transistor T2 and an internal switching manner of the amplifier 10 in different embodiments. In different embodiments of this application, the structure of the amplifier 10 may change as follows: An equalization transistor may or may not be disposed, a source of the equalization transistor is connected to the first node S1, and a drain of the equalization transistor is connected to the second node S2, and is configured to be turned on under control of an equalization signal, so as to pull potentials of the first node S1 and the second node S2 to be the same. In parallel, the first offset cancellation transistor M5 and the second offset cancellation transistor M6 may or may not be disposed. An internal switching manner of the amplifier changes as follows: At the idle stage, the first offset cancellation transistor M5 and the second offset cancellation transistor M6 are turned on or off.

In a case in which the equalization transistor is disposed, and a case in which the first/second offset cancellation transistor is turned on at the idle stage, the potentials of the first node S1 and the second node S2 in the amplifier 10 may be pulled to the precharge potential through the first column selection transistor M10 without requiring a second pass transistor, that is, a second column selection transistor M11. In a case in which the equalization transistor is not disposed, a case in which the first/second offset cancellation transistor is not disposed, and a case in which the first/second offset cancellation transistor is turned off at the idle stage, the first node S1 may be first pulled to the precharge potential through the first column selection transistor M10, and the first node S1 controls the corresponding first P-type amplification transistor M1 to be partially turned on, so that the potential of the second node S2 is adjusted to the precharge potential, or the second column selection transistor M11 is disposed, and the precharge potential is received through the second column selection transistor M11, so that the second node S2 is at the precharge potential.

At the idle stage, the first isolation transistor M3 and the second isolation transistor M4 are in an always-on state, and the first voltage node PCS and the second voltage node NCS may be at the precharge potential. At the read/write stage, the first isolation transistor M3 and the second isolation transistor M4 may be turned off in a part of a time period and turned on in a remaining time period as required, the first voltage node PCS may be set to the precharge potential or the supply voltage as required, the second voltage node NCS may be set to the precharge potential or the low level as required, and the supply voltage is generally about twice the precharge potential. As mentioned above, various arrangements of internal structures of the amplifier 10, whether the second pass transistor is disposed, and whether the first/second offset cancellation transistor (M5 or M6) is turned on or off at the idle stage all fall within the protection scope of this application.

In some embodiments, the offset cancellation transistor (M5 or M6 in FIG. 6) connected between the gate and the drain of the N-type amplification transistor is not disposed in the amplifier 10, and the isolation transistor is not disposed in the amplifier 10. Referring to FIG. 7, the amplifier 10 includes a first P-type amplification transistor M1, a second P-type amplification transistor M2, a first N-type amplification transistor M7, and a second N-type amplification transistor M8. A first terminal of the first P-type amplification transistor M1 and a first terminal of the second P-type amplification transistor M2 are connected to a first voltage node PCS. A second terminal of the first P-type amplification transistor M1 is connected to a first terminal of the first N-type amplification transistor M7, and a second terminal of the second P-type amplification transistor M2 is connected to a first terminal of the second N-type amplification transistor M8. A second terminal of the first N-type amplification transistor M7 and a second terminal of the second N-type amplification transistor M8 are connected to a second voltage node NCS. The second terminal of the first P-type amplification transistor M1 serves as the first node S1, and the second terminal of the second P-type amplification transistor M2 serves as the second node S2. The first node S1 is connected to a gate of the second P-type amplification transistor M2 and a gate of the second N-type amplification transistor M8, and the second node S2 is connected to a gate of the first P-type amplification transistor M1 and a gate of the first N-type amplification transistor M7.

In this embodiment, the amplifier 10 includes a P-type amplifier PSA and an N-type amplifier NSA. The P-type amplifier PSA includes a first P-type amplification transistor M1 and a second P-type amplification transistor. The N-type amplifier NSA includes a first N-type amplification transistor M7 and a second N-type amplification transistor M8. In another embodiment, the amplifier 10 includes only the P-type amplifier PSA and the N-type amplifier NSA.

In some embodiments, referring to FIG. 6, a first terminal of the first pass transistor (namely, the first column selection transistor M10) is electrically connected to the bit line Bla, and the first pass transistor is electrically connected to the first node S1 through the bit line Bla and the first isolation transistor M3. In this circuit, if the potential of the first node S1 needs to be adjusted when the first pass transistor is turned on, the first isolation transistor M3 needs to be further turned on at the same time, so that a path is formed between the first node S1 and the second data line Data2 (namely, the local data line IO). When an optional second pass transistor (namely, the second column selection transistor M11) is disposed in the memory circuit, a first terminal of the second pass transistor is electrically connected to the reference bit line Blb, and the second pass transistor is electrically connected to the second node S2 through the reference bit line Blb and the second isolation transistor M4. The potential of the second node S2 may be adjusted to the precharge potential by turning on the second pass transistor and the second isolation transistor M4.

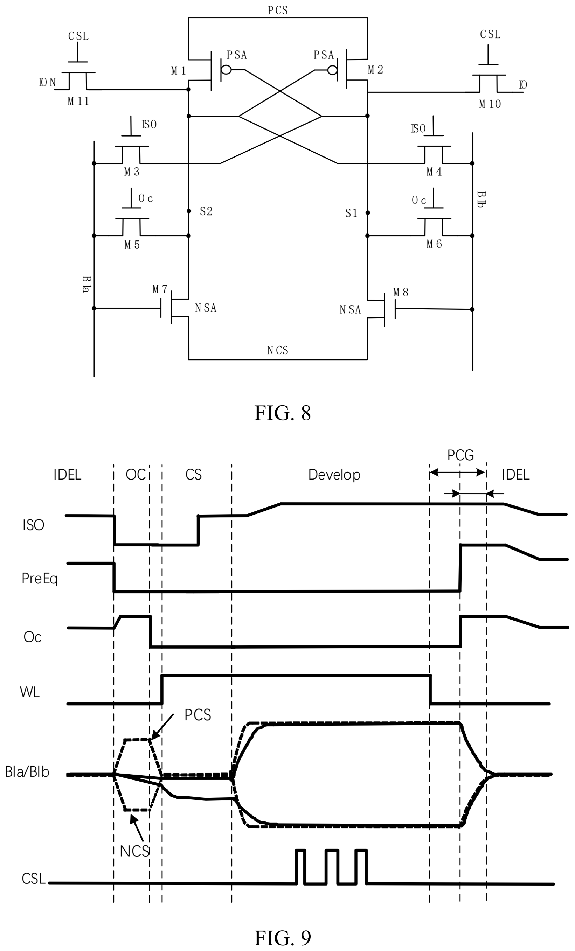

In some other embodiments, referring to FIG. 8, a first terminal of the first pass transistor (namely, the first column selection transistor M10) is electrically connected to the first node S1, and is electrically connected to the bit line Bla through the first node S1 and the first isolation transistor M3. In this circuit, the potential of the first node S1 may be adjusted only by turning on the first pass transistor, without a need to turn on the first isolation transistor M3 configured to isolate the first node S1 from the bit line Bla. In addition, because the first isolation transistor M3 isolates the bit line Bla from the first node S1, when capacitor sharing is performed between the memory cell and the bit line Bla, the first pass transistor may be turned on to adjust the potential of the first node S1 to the precharge potential, thereby ensuring that the amplifier 10 has a good initial state during subsequent amplification, provided that the first isolation transistor M3 and the second isolation transistor M4 are in an off state. When an optional second pass transistor (namely, the second column selection transistor M11) is disposed in the memory circuit, a first terminal of the second pass transistor is electrically connected to the second node S2, and is electrically connected to the reference bit line Blb through the second node S2 and the second isolation transistor M4.

In some embodiments, the read/write stage includes an offset cancellation stage, a charge sharing stage, and an amplification stage that are successively performed. The charge sharing stage is located between the offset cancellation stage and the amplification stage. The first pass transistor of the memory circuit shown in FIG. 8 is further configured to be turned on based on the control signal in at least a part of a time period at the charge sharing stage.

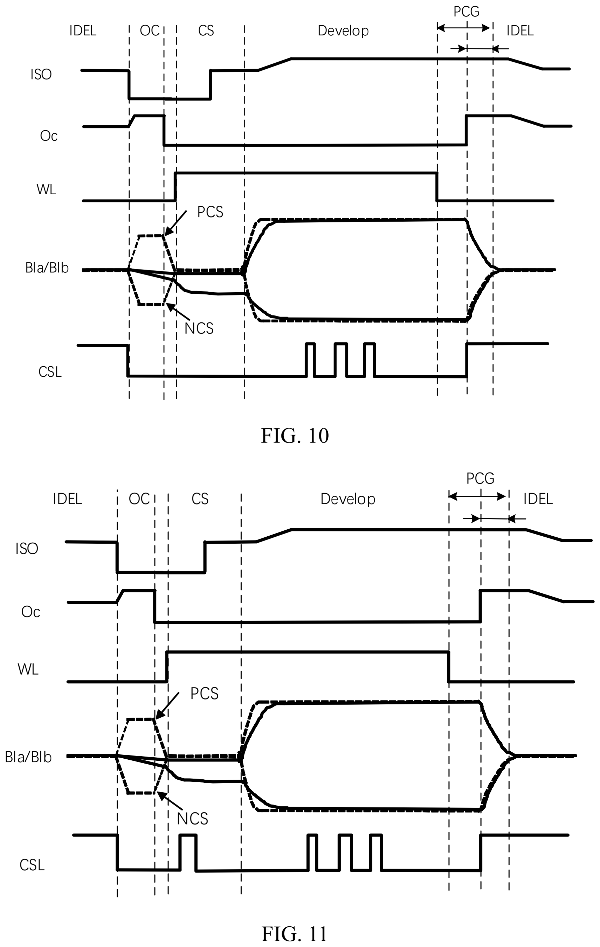

Reference is made to FIG. 9 to FIG. 11. FIG. 9 is a diagram of control signal timing and node potential changing of the memory circuit shown in FIG. 1. FIG. 10 is a diagram of control signal timing and node potential changing of the memory circuit shown in FIG. 6. FIG. 11 is a diagram of control signal timing and node potential changing of the memory circuit shown in FIG. 8. The diagrams of control signal timing and node potential changing provided in FIG. 9 to FIG. 11 include an idle stage Idel, an offset cancellation (OC) stage, a charge sharing (CS) stage, an amplification stage Develop, and a precharge (PCG) stage that are successively and repeatedly performed. A specific time interval may exist between different stages, and the different stages are not necessarily continuous strictly in terms of timing. It should be noted that, a start moment of the precharge stage may be a moment at which the word line WL is disconnected (a falling edge), or may be a moment at which the precharge signal PreEq is valid (a rising edge). In the diagram of control signal timing, an isolation signal ISO is a control signal of the first isolation transistor/the second isolation transistor, PreEq is a control signal of the precharge transistor, an offset cancellation signal Oc is a control signal of the first offset cancellation transistor/the second offset cancellation transistor, WL is a control signal of the word line, Bla/Blb are potentials of the bit line and the reference bit line, and PCS/NCS are potentials of the first voltage node and the second voltage node. In this application, in an example in which the first isolation transistor, the second isolation transistor, the precharge transistor, the first offset cancellation transistor, and the second offset cancellation transistor are all NMOS transistors, corresponding control signals are all valid at a high level. To be specific, when the foregoing control signal is at a high level, the corresponding transistor is controlled to be turned on.

In FIG. 9, a column selection signal CSL is completely at a low level at the idle stage Idle, and a corresponding column selection transistor is turned off. The column selection signal CSL presents a high-level pulse only at the amplification stage Develop, so as to turn on the column selection transistor and perform data reading/writing. Three pulses at the amplification stage in FIG. 9 are similar to four pulses at the read/write stage Active in FIG. 5, all of which show a quantity of column selection transistors that are turned on, instead of a quantity of times the same column selection transistor is turned on consecutively.

In FIG. 10, the column selection signal CSL not only presents a high-level pulse at the amplification stage Develop, but also is continuously at a high level at the idle stage Idle, so as to turn on the column selection transistor, so that the bit line Bla can receive the precharge potential of the local data line IO. In addition, because the isolation signal ISO and the offset cancellation signal Oc are also in a high-level state at the idle stage Idle, and the first isolation transistor, the second isolation transistor, the first offset cancellation transistor, and the second offset cancellation transistor are turned on, the potentials of the first node S1 and the second node S2 are pulled to the precharge potential.

It may be understood that a voltage of the local data line IO needs to be adjusted to the precharge potential before the isolation signal ISO is at a high level. In some embodiments, if a local reference data line ION is disposed, and the first isolation transistor and the second isolation transistor are turned on based on the same isolation signal ISO, the potential of the local reference data line ION also needs to be adjusted to the precharge potential before the isolation signal ISO is at a high level. In some other embodiments, the first isolation transistor and the second isolation transistor are turned on based on different isolation signals ISO that are independent of each other. For example, the first isolation transistor is turned on based on the first isolation signal, and the second isolation transistor is turned on based on the second isolation signal. At the idle stage, only the first isolation transistor may be controlled to be turned on, and the second isolation transistor may be controlled to be turned off. In this way, before the first isolation transistor is turned on, the potential of the local reference data line ION does not need to be adjusted to the precharge potential.

In the embodiment shown in FIG. 10, the column selection signal CSL is always in a high-level state at the idle stage Idle. However, in some other embodiments, the column selection signal CSL is in a high-level state only in a part of a time period, provided that the potential of the first node S1 can be adjusted to the precharge potential. A part of a time period in which the column selection signal CSL is at a high level may be one continuous time period, or may be at least two time periods that are spaced apart.

In FIG. 11, the column selection signal CSL also presents a high-level pulse at the charge sharing stage CS. Because both the offset cancellation signal Oc and the isolation signal ISO are at a low level in an initial period of the stage, interference between a change in the voltage of the bit line caused by charge sharing of the memory cell and a change in the voltage of the first node S1 in the amplifier is weak. Therefore, the potential of the first node S1 of the amplifier may be adjusted to the precharge potential before the first isolation transistor/second isolation transistor is turned on, thereby ensuring that the amplifier has a good initial state between amplification voltage differences.

In some embodiments, the first pass transistor is configured to be turned on based on the control signal generated by a column operation command in at least a part of a time period at the read/write stage, and be turned on based on the control signal generated by a row operation command in at least a part of a time period at the idle stage.

In some embodiments, the column operation command includes a read command and a write command. During execution of the read command or the write command, the column selection transistor between the bit line and the corresponding local data line IO needs to be turned on based on a column address to be read/written, and the pass transistor between the local data line IO and the corresponding global data line needs to be turned on, so as to implement data reading/writing. In this application, a command required for turning on the corresponding column selection transistor and pass transistor to perform reading/writing is referred to as a column operation command. Read data may not be output to the outside but only processed inside. Data to be written may not originate from the outside, but may originate from an internal register or from a data pattern randomly generated inside. In other words, the column operation command may be input from the outside into the memory, or may be generated internally.

In some embodiments, a row operation command includes a precharge command. During a validity period of the precharge command, the word line is disabled, a storage transistor is disconnected, and charge sharing is not performed between a storage capacitor and the bit line. In this case, the amplifier and the bit line may be precharged, so as to adjust the potential of the bit line and the potential of the first node electrically connected to the bit line in the amplifier to the precharge potential, thereby preparing for next data reading/writing. In another embodiment, the row operation command may further include a row activation command. Because a time interval between the precharge command and the row activation command is usually fixed inside the memory, a command signal having the same timing as the precharge command may be obtained by delaying the row activation command, and then a control signal is generated based on the delayed row activation signal, so as to turn on the first pass transistor.

In some embodiments, the first data line Data1 is the local data line, the first reference data line Data1# is the local reference data line, the second data line Data2 is the global data line, and the global data line is connected to the local data line through the first pass transistor T1, so as to adjust the potential at the first terminal of the first pass transistor T1 to be equal to the potential at the second terminal of the first pass transistor T1. During data reading, data is read from a memory cell, and gradually passes through the bit line, the local data line, and the global data line until the data is finally output to a data port.

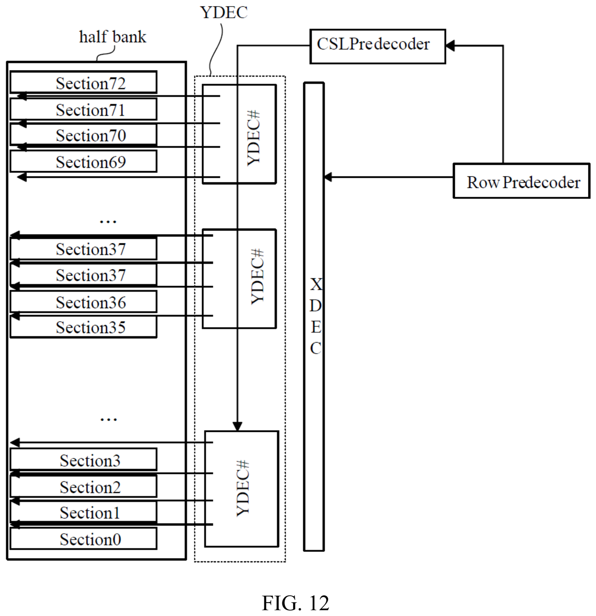

FIG. 12 is a schematic architectural diagram of a memory circuit according to an embodiment of this application. Referring to FIG. 12, in some embodiments, the memory circuit further includes a bank. The bank includes a row decoder XDEC, a column decoder YDEC, and a half bank located on two opposite sides of the row decoder XDEC. Both the amplifier 10 and the first pass transistor T1 are disposed in the half bank, and the column decoder YDEC is located between the row decoder XDEC and the half bank.

The row decoder XDEC, the column decoder YDEC, and the half bank are arranged in a direction of the word line. The row decoder XDEC is configured to decode a row address, and the column selector YDEC is configured to decode a column address. A decoding result of the row decoder XDEC may be a final decoding result, which directly determines a target word line to be activated, or may be an intermediate decoding result, which requires further decoding to determine a final target word line to be activated. In addition, a signal received by the row decoder XDEC may be an original address signal, or may be an address signal that has been decoded one or more times. The row decoder XDEC further decodes the received row address signal. Similarly, the column decoder YDEC may receive an original column address signal, or may receive an address signal that has been decoded one or more times, and may output a final bit line to be read/written, or may output column address information that further needs to be decoded.

In an embodiment, further referring to FIG. 12, it can be learned that the memory circuit further includes a row pre-decoding circuit Row Pre decoder and a column pre-decoding circuit CSL Pre decoder. The row pre-decoding circuit Row Pre decoder is configured to decode a row address for the first time, and the column pre-decoding circuit CSL Pre decoder is configured to decode a column address for the first time. In an embodiment, the row decoder XDEC decodes the row address for the second time, and a sub-word line driver SWD in the half bank decodes the row address for the third time, to finally determine the row address of the target word line and activate the target word line. The column decoder YDEC is configured to decode the column address for the second time to determine a final target bit line to be read/written. There is usually one target word line, and there are usually multiple target bit lines.

In some embodiments, the column decoder YDEC includes multiple column decoding circuits YDEC#, the half bank includes multiple sections (Section0 to Section72) arranged in a direction of a bit line, each of the column decoding circuits YDEC# is configured to perform column decoding for some sections in the multiple sections, and each of the column decoding circuits YDEC# corresponds to a fixed quantity of the sections.

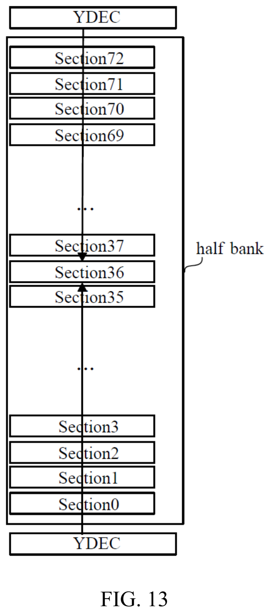

Referring to FIG. 13, FIG. 13 is a schematic architectural diagram of a memory circuit. In the schematic architectural diagram, the column decoder YDEC is located on two opposite sides of the half bank, and each column decoder YDEC corresponds to a half of the quantity of sections. As a capacity of the half bank increases, when a quantity of word lines included in each section remains unchanged and a quantity of bit lines included in each section remains unchanged, the quantity of sections also increases, and a quantity of sections corresponding to each column decoder also increases. In other words, a quantity of sections corresponding to the column decoder is not fixed. In addition, a signal transmission distance between the column decoder and the nearest section is denoted as a first distance, and a signal transmission distance between the column decoder and the farthest section is denoted as a second distance. As the quantity of sections increases, a difference between the first distance and the second distance is increasingly large. As a result, signal timing control is increasingly complex.

If each column decoding circuit YDEC# corresponds to a fixed quantity of sections, as the quantity of sections increases, the quantity of column decoding circuits YDEC# also needs to increase, and a signal transmission distance between each column decoding circuit and a corresponding section remains unchanged. The circuit architecture can be quickly applied to half banks with different capacities, thereby ensuring fast implementation of different projects.

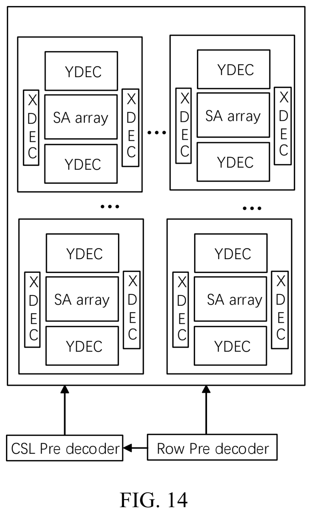

In some embodiments, referring to FIG. 14, the memory circuit further includes a first semiconductor structure and a second semiconductor structure that are stacked. The word line, the bit line, and the memory cell are all disposed in the first semiconductor structure, and multiple repeating units are disposed in the second semiconductor structure. Each repeating unit includes an amplification array SA array and a row decoder XDEC located on two opposite sides of the amplification array SA array in a first direction, and a column decoder YDEC located on two opposite sides of the amplification array SA array in a second direction. The first direction is perpendicular to the second direction. In this embodiment, the memory cell and the corresponding control circuit are disposed in different semiconductor structures, and each repeating unit may correspond to one bank. This helps reduce a signal transmission distance between the bank and the corresponding control structure, and improve control efficiency.

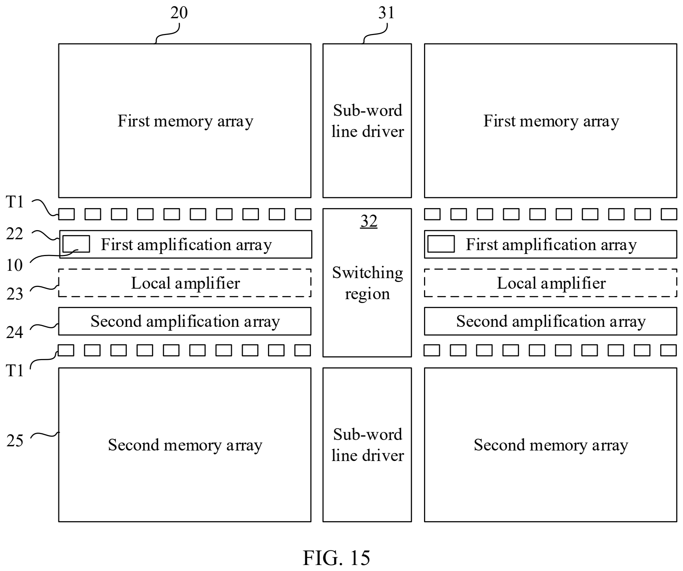

In some embodiments, referring to FIG. 15, the memory circuit further includes a first memory array 20, a second memory array 25, a first amplification array 22, and a second amplification array 24. The first memory array 20, the first amplification array 22, the second amplification array 24, and the second memory array 25 are successively arranged in an extension direction of the bit line. The amplifier 10 is disposed in the first amplification array 22 and the second amplification array 24. The first pass transistor T1 is disposed between the first amplification array 22 and the first memory array 20, and is disposed between the second amplification array 24 and the second memory array 25.

In some embodiments, a local amplifier 23 is further disposed between the first amplification array 22 and the second amplification array 24, and the local amplifier 23 is configured to amplify a voltage difference between the local data line IO and the local reference data line ION. In another embodiment, no local amplifier 23 is disposed between the first amplification array 22 and the second amplification array 24, and the local amplifier 23 is disposed in the switching region 32. Sub-word line drivers 31 are disposed on upper and lower sides of the switching region 32, and the first amplification array 22 and the second amplification array 24 are disposed on each of left and right sides of the switching region 32. The sub-word line drivers 31 are configured to drive and activate a word line, and the amplifiers 10 disposed in the first amplification array 22 and the second amplification array 24 are configured to amplify a voltage difference between the bit line Bla and the reference bit line Blb.

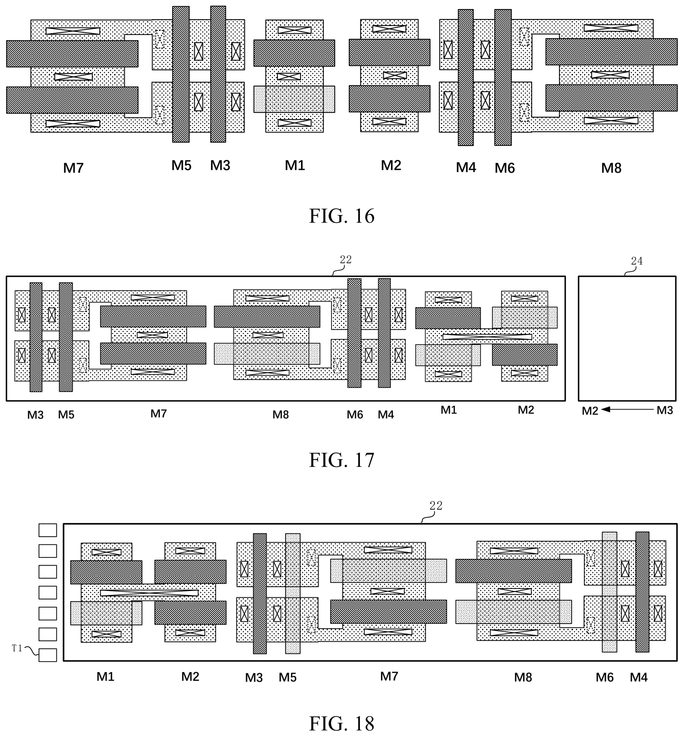

In some embodiments, in the extension direction of the bit line, referring to FIG. 16, in the amplifier 10, the first N-type amplification transistor M7, the first offset cancellation transistor M5, the first isolation transistor M3, the first P-type amplification transistor M1, the second P-type amplification transistor M2, the second isolation transistor M4, the second offset cancellation transistor M6, and the second N-type amplification transistor M8 are successively arrange. In this way, the amplifier 10 has a symmetrical layout floorplan. Positions of the first isolation transistor M3 and the first offset cancellation transistor M5 may be interchanged. To maintain symmetry of the layout floorplan and signal connection lines, positions of the second isolation transistor M4 and the second offset cancellation transistor M6 may also be interchanged synchronously.

In some other embodiments, in the extension direction of the bit line, referring to FIG. 17, in the amplifier 10, the first isolation transistor M3, the first offset cancellation transistor M5, the first N-type amplification transistor M7, the second N-type amplification transistor M8, the second offset cancellation transistor M6, the second isolation transistor M4, the first P-type amplification transistor M1, and the second P-type amplification transistor M2 are successively arranged. In this way, when the first amplification array 22 and the second amplification array 24 are adjacent to each other, and the layout structures are arranged in opposite directions, P-type MOS transistors in the first amplification array and the second amplification array may be controlled to share a P-type substrate, provided that no other structure is disposed or only the P-type MOS transistor is disposed between the first amplification array 22 and the second amplification array 24.

In still some embodiments, in the extension direction of the bit line, in the amplifier 10, the first P-type amplification transistor M1, the second P-type amplification transistor M2, the first isolation transistor M3, the first offset cancellation transistor M5, the first N-type amplification transistor M7, the second N-type amplification transistor M8, the second offset cancellation transistor M6, and the second isolation transistor M4 are successively arranged. In this way, the first P-type amplification transistor M1 and the second P-type amplification transistor M2 may be employed to isolate the NMOS transistor and the first pass transistor T1 in the first amplification array 22, and isolate the NMOS transistor and the first pass transistor T1 in the second amplification array 24. When the first pass transistor T1 is an NMOS transistor, the NMOS transistor and the first pass transistor T1 in the first amplification array 22/second amplification array 24 may employ N-type substrates with different substrate voltages.

In some embodiments, referring to FIG. 17 and FIG. 18, the first offset cancellation transistor M5 shares an active region with the first N-type amplification transistor M7, and the shared active region is connected to a metal layer through a corresponding contact hole. It can be learned from the figures that, the active region on the side of the first offset cancellation transistor M5 is combined with the active region on the side of the first N-type amplification transistor M7. Only a contact hole in the active region on the side of the first N-type amplification transistor M7 is retained, and the active region is connected to an upper metal layer through the contact hole. A contact hole in the active region on the side of the first offset cancellation transistor M5 is removed (indicated by a dotted line).

In another embodiment, a contact hole in the active region on the side of the first N-type amplification transistor M7 may alternatively be removed, and a contact hole in the active region on the side of the first offset cancellation transistor M5 is retained. Similarly, the second offset cancellation transistor M6 and the second N-type amplification transistor M8 may also share an active region, and the shared active region is connected to the metal layer through a corresponding contact hole. In some embodiments, referring to FIG. 17 and FIG. 18, the first P-type amplification transistor M1 and the second P-type amplification transistor M2 share an active region, and the shared active region is connected to the metal layer through a corresponding contact hole.

A person of ordinary skill in the art may understand that the foregoing implementations are specific embodiments for implementing this application. In actual application, various modifications may be made to the forms and details of the implementations without departing from the spirit and scope of this application. Any person skilled in the art may make changes and modifications without departing from the spirit and scope of this application. Therefore, the protection scope of this application shall be subject to the scope defined by the claims.

## Claims

1. A memory circuit, comprising:
an amplifier, the amplifier having a first node and a second node, the first node being electrically connected to a first data line, the second node being electrically connected to a first reference data line, and the amplifier being configured to amplify a voltage difference between the first data line and the first reference data line; and
a first pass transistor, a first terminal of the first pass transistor being electrically connected to the first node, a second terminal of the first pass transistor being electrically connected to a second data line, and the first pass transistor being configured to be turned on based on a control signal in at least a part of a time period at a read/write stage, and be turned on based on the control signal in at least a part of a time period at an idle stage.

2. The memory circuit according to claim 1, further comprising a second pass transistor, a first terminal of the second pass transistor being electrically connected to the second node, a second terminal of the second pass transistor being electrically connected to a second reference data line, and at least one of the first pass transistor and the second pass transistor being configured to be turned on based on a control signal in at least a part of a time period at a read/write stage, and be turned on based on the control signal in at least a part of a time period at an idle stage.

3. The memory circuit according to claim 2, wherein at a same idle stage, the first pass transistor or the second pass transistor is turned on, and at different idle stages, the first pass transistor and the second pass transistor are turned on alternately.

4. The memory circuit according to claim 1, wherein the first data line is a bit line, the first reference data line is a reference bit line, the second data line is a local data line, the first pass transistor is a first column selection transistor, the local data line is electrically connected to the bit line through the first column selection transistor, the control signal is a column selection signal, and the first column selection transistor is turned on based on the column selection signal to adjust a potential of the first node to be equal to a potential of the local data line.

5. The memory circuit according to claim 4, wherein the amplifier comprises a first P-type amplification transistor, a second P-type amplification transistor, a first N-type amplification transistor, and a second N-type amplification transistor; a first terminal of the first P-type amplification transistor and a first terminal of the second P-type amplification transistor are connected to a first voltage node, a second terminal of the first P-type amplification transistor is connected to a first terminal of the first N-type amplification transistor, a second terminal of the second P-type amplification transistor is connected to a first terminal of the second N-type amplification transistor, a second terminal of the first N-type amplification transistor and a second terminal of the second N-type amplification transistor are connected to a second voltage node, the second terminal of the first P-type amplification transistor serves as the first node, the second terminal of the second P-type amplification transistor serves as the second node, the first node is connected to a gate of the second P-type amplification transistor and a gate of the second N-type amplification transistor, and the second node is connected to a gate of the first P-type amplification transistor and a gate of the first N-type amplification transistor.

6. The memory circuit according to claim 4, wherein the amplifier comprises a first P-type amplification transistor, a second P-type amplification transistor, a first N-type amplification transistor, a second N-type amplification transistor, a first isolation transistor, a second isolation transistor, a first offset cancellation transistor, and a second offset cancellation transistor; a first terminal of the first P-type amplification transistor and a first terminal of the second P-type amplification transistor are connected to a first voltage node, a second terminal of the first P-type amplification transistor is connected to a first terminal of the first N-type amplification transistor, a second terminal of the second P-type amplification transistor is connected to a first terminal of the second N-type amplification transistor, a second terminal of the first N-type amplification transistor and a second terminal of the second N-type amplification transistor are connected to a second voltage node, the second terminal of the first P-type amplification transistor serves as the second node, the second terminal of the second P-type amplification transistor serves as the first node, and the first node is connected to a first terminal of the first isolation transistor and a gate of the first P-type amplification transistor; a second terminal of the first isolation transistor, a second terminal of the first offset cancellation transistor, and a gate of the first N-type amplification transistor are connected to the bit line; a first terminal of the first offset cancellation transistor is connected to the second node, and the second node is connected to a first terminal of the second isolation transistor and a gate of the second P-type amplification transistor; a second terminal of the second isolation transistor, a second terminal of the second offset cancellation transistor, and a gate of the second N-type amplification transistor are connected to the reference bit line; a first terminal of the second offset cancellation transistor is connected to the first node, the first isolation transistor and the second isolation transistor are turned on based on an isolation signal, and the first offset cancellation transistor and the second offset cancellation transistor are turned on based on an offset cancellation signal.

7. The memory circuit according to claim 6, wherein the first terminal of the first pass transistor is electrically connected to the bit line and is electrically connected to the first node through the bit line and the first isolation transistor.

8. The memory circuit according to claim 6, wherein the first terminal of the first pass transistor is electrically connected to the first node and is electrically connected to the bit line through the first node and the first isolation transistor.

9. The memory circuit according to claim 8, wherein the read/write stage comprises an offset cancellation stage, a charge sharing stage, and an amplification stage that are successively performed, and the first pass transistor is further configured to be turned on based on the control signal in at least a part of a time period at the charge sharing stage, and at the charge sharing stage, a turn-on moment of the first isolation transistor and the second isolation transistor is later than a turn-off moment of the first pass transistor.

10. The memory circuit according to claim 1, wherein the first pass transistor is configured to be turned on based on the control signal generated by a column operation command in at least a part of a time period at the read/write stage, and be turned on based on the control signal generated by a row operation command in at least a part of a time period at the idle stage.

11. The memory circuit according to claim 10, wherein the column operation command comprises a read command and a write command, and the row operation command comprises a precharge command.

12. The memory circuit according to claim 1, wherein the first data line is a local data line, the first reference data line is a local reference data line, the second data line is a global data line, and the global data line is connected to the local data line through the first pass transistor to adjust a potential at the first terminal of the first pass transistor to be equal to a potential at the second terminal of the first pass transistor.

13. The memory circuit according to claim 1, further comprising:
a bank, the bank comprising a row decoder, a column decoder, and a half bank located on two opposite sides of the row decoder, both the amplifier and the first pass transistor being disposed in the half bank, and the column decoder being located between the row decoder and the half bank.

14. The memory circuit according to claim 13, wherein the column decoder comprises a plurality of column decoding circuits, the half bank comprises a plurality of sections arranged in a direction of a bit line, each of the column decoding circuits is configured to perform column decoding for some corresponding sections in the plurality of sections, and each of the column decoding circuits corresponds to a fixed quantity of the sections.

15. The memory circuit according to claim 4, further comprising a first semiconductor structure and a second semiconductor structure that are stacked, the bit line and a memory cell connected to the bit line being disposed in the first semiconductor structure, a plurality of repeating units being disposed in the second semiconductor structure, each repeating unit comprising an amplification array and a row decoder located on two opposite sides of the amplification array in a first direction, and a column decoder located on two opposite sides of the amplification array in a second direction, and the first direction being perpendicular to the second direction.

16. The memory circuit according to claim 6, further comprising a first memory array, a second memory array, a first amplification array, and a second amplification array; the first memory array, the first amplification array, the second amplification array, and the second memory array being successively arranged in an extension direction of the bit line; the amplifier being disposed in the first amplification array and the second amplification array; and the first pass transistor being disposed between the first amplification array and the first memory array, and being disposed between the second amplification array and the second memory array.

17. The memory circuit according to claim 16, wherein a local amplifier is further disposed between the first amplification array and the second amplification array, and the local amplifier is configured to amplify a voltage difference between the local data line and a local reference data line.

18. The memory circuit according to claim 16, wherein in the extension direction of the bit line, in the amplifier, the first N-type amplification transistor, the first offset cancellation transistor, the first isolation transistor, the first P-type amplification transistor, the second P-type amplification transistor, the second isolation transistor, the second offset cancellation transistor, and the second N-type amplification transistor are successively arranged; or
the first isolation transistor, the first offset cancellation transistor, the first N-type amplification transistor, the second N-type amplification transistor, the second offset cancellation transistor, the second isolation transistor, the first P-type amplification transistor, and the second P-type amplification transistor are successively arranged; or
the first P-type amplification transistor, the second P-type amplification transistor, the first isolation transistor, the first offset cancellation transistor, the first N-type amplification transistor, the second N-type amplification transistor, the second offset cancellation transistor, and the second isolation transistor are successively arranged.

19. The memory circuit according to claim 18, wherein the first offset cancellation transistor shares an active region with the first N-type amplification transistor, and the shared active region is connected to a metal layer through a corresponding contact hole.
